Europäisches Patentamt

European Patent Office

Office européen des brevets

(19)

(11) Publication number: **0 284 190 B1**

# EUROPEAN PATENT SPECIFICATION

(12)

(45) Date of publication of patent specification: **25.11.92**  (51) Int. Cl.5: **C23C  16/26**

(21) Application number: **88301364.1**

(22) Date of filing: **18.02.88**

(54) **Enhanced CVD method for deposition of carbon.**

(30) Priority: **24.02.87 JP 41748/87**
        **13.07.87 JP 175560/87**

(43) Date of publication of application:
     **28.09.88 Bulletin  88/39**

(45) Publication of the grant of the patent:
     **25.11.92 Bulletin  92/48**

(84) Designated Contracting States:
     **DE FR GB**

(56) References cited:
     **DE-A- 2 065 431**

     **JOURNAL OF VACUUM SCIENCE & TECH-
     NOLOGY A, vol. 4, no. 2, March/April 1986,
     2nd series, American Vacuum Society, New
     York, NY (US); J.KIESER et al., pp.
     222-225&NUM;**

     **CHEMICAL ABSTRACTS, vol. 92, no. 12, 24
     March 1980, Columbus, OH (US);
     V.E.STREL'NITSKII et al., p. 262, no.
     98365v&NUM;**

     **PATENT ABSTRACTS OF JAPAN, vol. 7, no.
     132 (E-180)[1277], 09 June 1983&NUM;**

     **PATENT ABSTRACTS OF JAPAN, vol. 9, no.
     21 (C-263)[1744], 29 January 1985&NUM;**

     **PATENT ABSTRACTS OF JAPAN, vol. 4, no.
     34 (C-3)[516], 22 March 1980&NUM;**

(73) Proprietor: **SEMICONDUCTOR ENERGY LAB-
     ORATORY CO., LTD.
     398 Hase
     Atsugi-shi Kanagawa-ken, 243(JP)**

(72) Inventor: **Yamazaki, Shunpei
     21-21 Kitakarasuyama 7-Chome
     Setagaya-Ku Tokyo, 157(JP)**

(74) Representative: **Milhench, Howard Leslie et al
     R.G.C. Jenkins & Co. 26 Caxton Street
     London SW1H 0RJ(GB)**

EP 0 284 190 B1

## Description

### BACKGROUND OF THE INVENTION

This invention relates to an enhanced CVD method for the production of carbon thin films.

Recently, ECR (Electron Cyclotron Resonance) CVD has attracted the interest of researchers as a new method of manufacturing thin films, particularly amorphous thin films. For example, Matsuo et al discloses one type of such an ECR CVD apparatus in US-A 4,401,054. This recent technique utilizes microwave energy to energize a reactive gas such that it develops into a plasma. A magnetic field functions to pinch the reactive gas within an excitation space within which the reactive gas can absorb the microwave energy. A substrate to be coated is located distant from the excitation space (resonating space) for preventing the same from being sputtered. The energized gas is showered onto the substrate from the resonating space. In order to establish electron cyclotron resonance, the pressure in the resonating space is kept at 0.13 to $0.0013 N/m^2$ ($1 \times 10^{-3}$ to $1 \times 10^{-5}$ Torr) at which pressure electrons can be considered as independent particles and will resonate with the microwave energy in an electron cyclotron resonance wherever the magnetic field strength meets the requirements for ECR. The excited plasma is extracted from the resonating space by means of a divergent magnetic field, and is conducted to a deposition space which is located distant from the resonating space and in which there is disposed a substrate to be coated.

In such a prior art method, it is very difficult to form a thin film having a polycrystalline or single-crystalline structure, so that currently available methods are substantially limited to processes for manufacturing amorphous films. Also, a high energy chemical vapor reaction cannot readily be accomplished by such prior art methods and therefore it has not been possible to form diamond films or other films having high melting points. Furthermore, uniform films cannot readily be formed on a surface having depressions and cavities.

Furthermore, it has been impossible to coat the surface of a super hard compound, such as tungsten carbide for example, with a carbon film. Because of this, it has been necessary in the abrasives industry to coat a super hard surface with a fine powder of diamond of sufficient hardness and to provide a sturdy mechanical contact between the diamond powder and the substrate surface.

Reference may further be made to the article "Large scale microwave plasma polymerization : a study on hydrogenated carbon films" by Kieser and Sellschopp published in J.Vac.Sci. Technol. vol A4 (1986) March/April, No.2, Second Series, pages 222 to 225. This article describes a systematic investigation of the pressure changes in low pressure microwave discharges of $C_2H_2$, $C_2H_4$ and $C_2H_6$, respectively, with Ar as a carrier gas, as a function of plasma power and admixture of nitrogen. The results are discussed in terms of the generation of clusters of active species in the plasma volume. Properties of plasma polymerized layers from these monomers with and without the admixture of nitrogen are investigated with respect to their anticorrosion behaviour as well as their wear resistance.

### SUMMARY OF THE INVENTION

It is therefore an object of the present invention to provide an enhanced CVD method for depositing carbon.

According to the present invention there is provided a chemical vapor deposition (CVD) method for the deposition of a diamond or diamond-like carbon film, said method comprising the introduction of a reactive gas comprising a gaseous carbon compound with admixture of nitrogen into a CVD reaction chamber and the application of electromagnetic energy to excite said carbon compound whereby carbon may be deposited by a chemical vapor deposition reaction, as known for example from the Kieser and Sellschopp article aforementioned, the method according to the invention being characterized in that the admixed nitrogen is introduced as nitrogen gas and/or a gaseous nitrogen compound in an amount such that the deposited carbon contains 0.01 to 1.0 weight % of nitrogen.

In accordance with the present invention, therefore, in addition to a carbon compound gas, a specific amount of nitrogen and/or a nitrogen compound gas is introduced into the reaction chamber. The added nitrogen functions to prevent lattice defects from growing by virtue of external or internal stress. In contrast to the results published in the Kieser and Sellschopp article aforementioned, in accordance with which the addition of nitrogen is said to exhibit an unfavourable influence on wear resistance, the method of the present invention has been found to result in carbon films of significantly improved hardness and correspondingly improved wear resistance. As a further feature of the invention, a boron compound gas may also be introduced with the nitrogen compound gas and serves to enhance the adhesivity of the deposited carbon, boron nitride appearing to be the binder between the carbon and the underlying substrate. Carbon and boron nitride may advantageously be deposited on the substrate in the form of crystalline grain particles or in a layer containing nitrogen and boron at less than 10%.

The invention proposes to employ an improved CVD process which utilizes a mixed cyclotron resonance. In accordance with the improved exciting process, sonic action of the reactive gas itself must be taken into consideration as a non-negligible perturbation besides the interaction between respective particles of the reactive gas and the magnetic and microwave energy fields, and as a result charged particles of reactive gas can be absorbed in a relatively wide resonating space. In order to achieve mixed resonance, the pressure in the reaction chamber is elevated to $10^2$-$10^5$ times as high as that utilized in the prior art. For example, mixed resonance can be established by increasing the pressure after ECR takes place at low pressure; first a plasma gas is placed in ECR condition at 0.13 to 0.0013 $N/m^2$ (1 x $10^{-3}$ to 1 x $10^{-5}$ Torr) by inputting microwave energy under the influence of a magnetic field, and then a reactive gas is inputted into the plasma gas so that the pressure is elevated to 13.3 to 4 x $10^4$ $N/m^2$ (0.1 to 300 Torr), preferably greater than 4 x $10^2$ $N/m^2$ (3 Torr), and the resonance is changed from ECR to MCR (Mixed Cyclotron Resonance). Carbon can be decomposed and can undergo the required reaction only at such a comparatively high pressure. In operation of the process, diamond is likely to grow selectively on convexities.

Although carbon is also deposited in an amorphous phase whereas the diamond state is preferred, hydrogen in a plasma state acts as an etchant to preferentially eliminate amorphous carbon thereby leaving crystalline carbon.

It has been found that the hardness of diamond formed in accordance with the present invention is 1.3 to 3.0 times as high as that of diamond which has been made by prior art vapor phase methods.

Further features of the present invention are set forth in the appended claims and they, together with the features described above, will become clear to those possessed of the relevant skills from a reading of the following description made with reference to the accompanying drawings.

## BRIEF DESCRIPTION OF THE DRAWINGS

Fig. 1 is a cross sectional view showing an exemplary CVD apparatus which may be utilized in the practice of the present invention;
Fig. 2(A) is a graphical diagram showing a computer simulation of the profiles of the equipotential surfaces in a cross section through a magnetic field developed in the apparatus of Fig. 1;
Fig. 2(B) is a graphical diagram showing a computer simulation of the strength of an electric field developed in the apparatus of Fig.1; and
Figs. 3(A) and 3(B) are graphical diagrams showing the distribution of magnetic and electric fields respectively arising from the propagation of microwave energy into a resonating space of the apparatus of Fig.1.

## DETAILED DESCRIPTION OF THE EMBODIMENTS

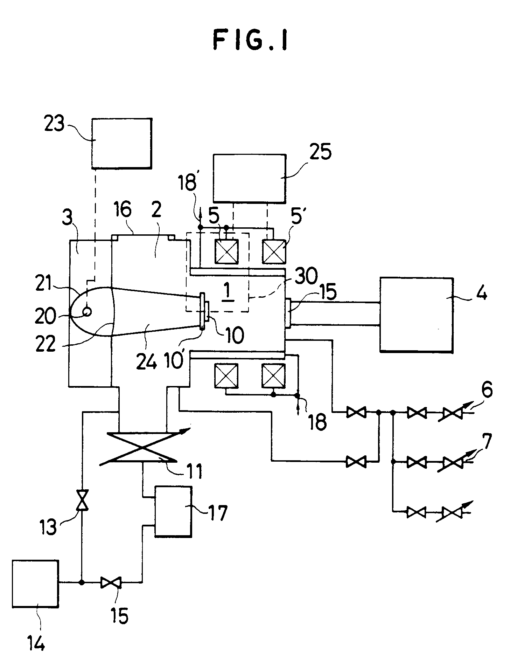

Referring to Fig.1, an exemplary microwave enhanced plasma CVD apparatus which may be utilized in the practice of the present invention is illustrated. As shown in the figure, the apparatus comprises a reaction chamber defining a plasma generating space 1 and an auxiliary space 2 which can be maintained at an appropriate negative pressure, a microwave generator 4, electro-magnets 5 and 5' in the form of Helmholtz coils surrounding the space 1, a power supply 25 for supplying the electro-magnets 5 and 5', and a water cooling system 18. For evacuating the reaction chamber there is provided an evacuating system comprising a turbo molecular pump 17 and a rotary pump 14 which are connected to the reaction chamber through pressure controlling valves 11, 13 and 15.

The plasma generating space 1 has a circular cross section and, within the plasma generating space 1, there is provided a substrate holder 10' upon which a substrate 10 may be mounted, the substrate holder 10' being made of a material such as stainless steel or quartz which provokes minimum disturbance of the magnetic field created by the magnets 5 and 5'. The substrate holder 10' is irradiated and heated to 800-1000°C in a high temperature plasma gas atmosphere by means of infrared radiation 24 which is emitted from an IR heater 20, reflected from an IR reflection parabolic mirror 21 and focused on the back surface of the holder 10' through a lens 22. Reference numeral 23 designates a power supply for the IR heater 20. The substrate temperature may reach a sufficient level solely by virtue of the plasma gas generated in the reaction chamber and in this case the heater 20 can be dispensed with. Further, depending on the condition of the plasma, the substrate temperature might become too high to enable a suitable reaction to occur, in which case cooling means for the substrate has to be provided.

In use of the above described apparatus, a substrate 10 is mounted on the substrate holder 10', and the reaction chamber is evacuated to 1.3 x $10^{-4}$ $N/m^2$ (1 x $10^{-6}$ Torr) or to a higher vacuum condition. Then, hydrogen gas is introduced from a gas introducing system 6 at 30 SCCM, and microwave energy at a power level of 500 Watts and a frequency of 2.45GHz is injected from the microwave generator 4 through a microwave introduction window 15 into the plasma generating space 1 which is subjected at the same time to a magnetic field of about 2 k Gauss generated by the magnets 5 and 5'. The hydrogen is excited into a high density plasma state in the space 1 at $1.3 \times 10^{-2}$ $N/m^2$ ($1 \times 10^{-4}$ Torr) by the microwave energy. The surface of the substrate 10 is cleaned by high energy electrons and hydrogen atoms. In addition to the introduction of hydrogen gas, a productive gas comprising a carbon compound such as $C_2H_2$, $C_2H_4$, $C_2H_6$, $CH_3OH$, $C_2H_5OH$ or $CH_4$ for example is inputted at 30 SCCM through a gas introduction system 7. In this process, the productive gas is diluted with hydrogen at a sufficiently low density, e.g 0.1 to 5%. Further, nitrogen or a nitrogen compound gas, such as ammonia for example, is inputted to the reaction chamber from the introduction system, the proportion of the nitrogen compound gas to the carbon compound gas being 0.1%-5%. The pressure in the reaction chamber is then maintained at 13.3 to $4 \times 10^4$ $N/m^2$ (0.1 Torr-300 Torr), preferably $4 \times 10^2$ to $4 \times 10^3$ $N/m^2$ (3-30 Torr), e.g. $1.3 \times 10^3$ $N/m^2$ (10 Torr). By increasing this pressure in the reaction chamber, it is possible to increase the density of the productive gas and, therefore, accelerate the growth rate of the product. The CVD reaction which occurs results from carbon atoms being excited to a high energy condition so that the substrate 10 mounted on the holder 10' is coated with carbon in the form of a film made of i-carbon (insulated carbon consisting of microcrystals) or diamond having a grain diameter of from $1 \times 10^{-7}$ to $1 \times 10^{-4}$ m (0.1 to 100 microns). The deposited carbon contains nitrogen at 0.01 - 1% by weight.

Polishing experiments have been conducted using abrasives coated with nitrogen-containing diamond produced as above described in accordance with the present invention and using abrasives coated with prior art diamond devoid of nitrogen for the purposes of comparison, and it has been found that the degradation of the polishing power of the former was half or less of that of the latter. These experiments establish that the nitrogen-containing diamond produced in accordance with the invention has a high resistance to wear.

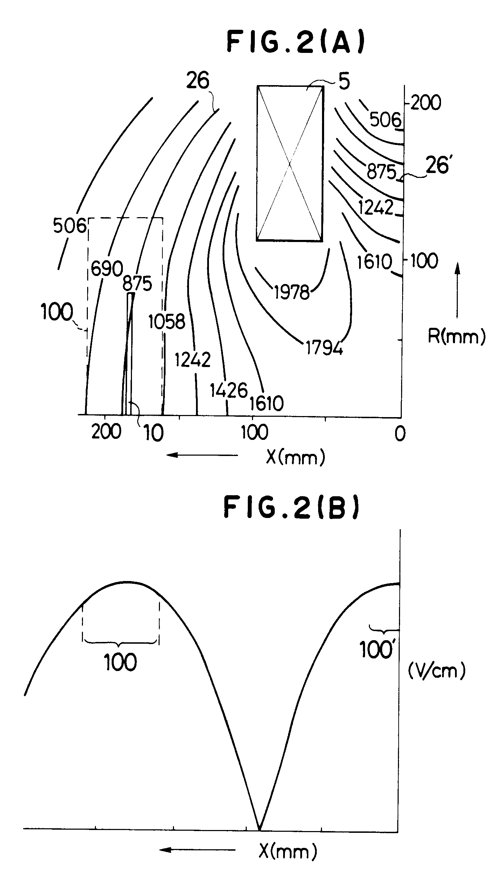

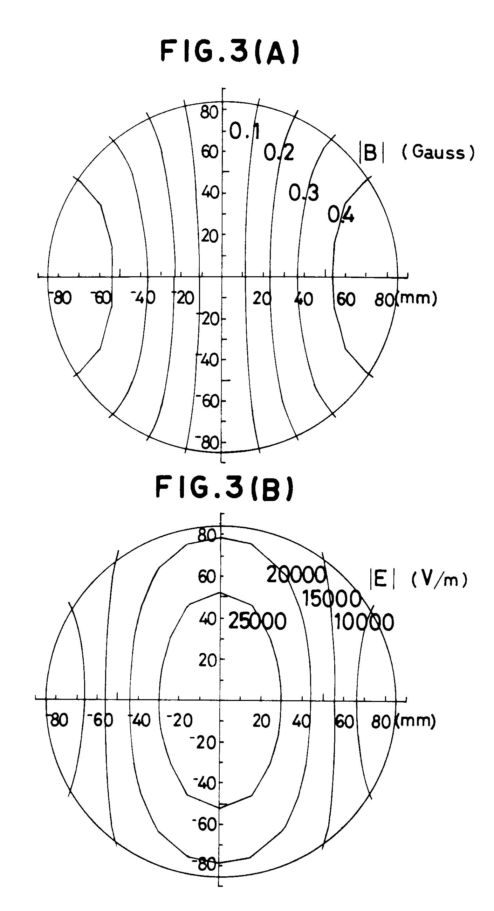

Fig. 2(A) is a graphical showing of the distribution of the magnetic field in the region 30 in Fig.1. The curves in the diagram are plotted along equipotential surfaces and are given numerals indicating the strengths along the respective curves of the magnetic field induced by magnets 5 and 5' having a power of 2000 Gauss. By adjusting the power of the magnets 5 and 5', the strength of the magnetic field can be controlled so that the magnetic field becomes largely uniform over the surface to be coated which is located in the region 100 where the magnetic field (875 ± 185 Gauss) and the electric field interact. In the diagram, the reference 26 designates the equipotential surface of 875 Gauss at which the conditions required for ECR (electron cyclotron resonance) between the magnetic field and the microwave energy are satisfied. Of course, in the practice of the present invention, ECR cannot be established due to the high pressure in the reaction chamber, but instead a mixed cyclotron resonance (MCR) takes place in a broad region including the equipotential surface which satisfies ECR conditions. Fig.2(B) is a graphical diagram in which the X-axis corresponds to that of Fig.2(A) and which shows the strength of the electric field of the microwave energy in the plasma generating space 1. As shown, the electric field strength takes its maximum value in the regions 100 and 100'. However, in the region 100', it is difficult to heat the substrate 10' without disturbing the propagation of the microwave energy. In other regions, a film will not be uniformly deposited, but will be deposited in the form of a doughnut. It is for this reason that the substrate 10 is disposed in the region 100. The plasma flows in the lateral direction. According to experiments, a uniform film can be formed on a circular substrate having a diameter of up to 100mm, and a film can be formed in the chamber on a circular substrate having a diameter of up to 50 mm with a uniform thickness and a uniform quality. When a larger substrate is desired to be coated, the diameter of the space 1 can be doubled with respect to the vertical direction of Fig.2(A) by making use of 1.225 GHz as the frequency of the microwave energy. Figs.3(A) and 3(B) are graphical diagrams showing the distributions of the magnetic field and the electric field due to microwave energy emitted from the microwave generator 4 for a cross section of the plasma generating space 1. The curves in the circles of the figures are plotted along equipotential surfaces and given numerals showing the field strengths. As shown in Fig.3(B), the electric field reaches its maximum value at 25 kV/m.

By a similar process, amorphous or microcrystalline film can also be deposited by appropriately selecting the deposition conditions. An amorphous film is deposited when the carbon compound gas is diluted with a larger amount of hydrogen gas, when the input power is comparatively small and when the process temperature is comparatively low. When a DC bias current is superimposed on the alternating current in the deposition conditions suitable for production of amorphous films, the deposited film includes a microcrystalline structure.

It is a significant feature of the invention that the carbon formed in accordance with the invention has a very high hardness irrespective of whether the carbon is amorphous or crystalline. Its Vickers hardness is at least of the order of 2000 $Kg/mm^2$. The thermal conductivity is not lower than 2.5 W/cmdeg, e.g. 5.0-6.6 W/cmdeg.

In accordance with a further feature of the present invention, a super lattice structure can be also formed. A boron nitride (BN) thin film may be deposited in the same way as illustrated in the above with nitrogen or a nitrogen compound gas such as ammonia, $NO_2$ or NO for example, and $B_2H_6$ or $BF_3$ inputted to the reaction chamber but without using any carbon compound gas, and carbon thin film and a BN thin film may be deposited in turn many times so that a super lattice structure is stacked on a substrate.

The invention is not limited to the above particular embodiments and many modifications and variations may occur to those skilled in the art without departure from the scope of the invention as set forth in the appended claims. For example, it has been proved effective to add aluminium or phosphorous into the carbon at 0.001 to 1 weight %. Furthermore, although the reactive gas is caused to flow from right to left in the Fig.1 apparatus, the system could be designed so that the gas flows from left to right, or upwards or downwards.

## Claims

1. A chemical vapor deposition (CVD) method for the deposition of a diamond, diamond-like or amorphous carbon film, said method comprising the introduction of a reactive gas comprising a gaseous carbon compound with admixture of nitrogen into a CVD reaction chamber and the application of electromagnetic energy to excite said carbon compound whereby carbon may be deposited by a chemical vapor deposition reaction, the method being characterized in that the admixed nitrogen is introduced as nitrogen gas and/or a gaseous nitrogen compound in an amount such that the deposited carbon contains 0.01 to 1.0 weight % of nitrogen.

2. A method as claimed in claim 1 wherein the electromagnetic excitation energy includes microwave energy.

3. A method as claimed in claim 2 wherein the frequency of said microwave energy is 2.45 GHz.

4. A method as claimed in claim 2 or 3 wherein the reaction chamber is subjected to a magnetic field and the excitation of the reactive gas containing a gaseous carbon compound and nitrogen or a gaseous nitrogen compound by the microwave energy is effected under the influence of said magnetic field.

5. A method as claimed in claim 4 wherein said deposition is carried out under the influence of a magnetic field of at least 1 kilo Gauss.

6. A method as claimed in claim 4 or 5 wherein the reactive gas is excited in a mixed cyclotron resonance.

7. A method as claimed in claim 6 wherein the pressure in said reaction chamber is chosen to be between $13.3 N/m^2$ and $4 \times 10^4 N/m^2$ (0.1 Torr and 300 Torr).

8. A method as claimed in any preceding claim wherein the gaseous nitrogen compound is ammonia.

9. A method as claimed in any preceding claim wherein said reactive gas includes at least one hydrocarbon constituting said gaseous carbon compound.

10. A method as claimed in claim 9 wherein the said hydrocarbon comprises $C_2H_2$, $C_2H_4$ or $C_2H_6$.

11. A method as claimed in any preceding claim wherein the reactive gas further includes a gaseous boron compound.

12. A method as claimed in any preceding claim wherein said carbon layer is deposited as a crystalline layer or a microcrystalline layer.

13. A method as claimed in any of claims 1 to 11 wherein said carbon layer is deposited as an amorphous layer.

14. A method as claimed in any preceding claim wherein said carbon layer is repeatedly deposited alternately with the deposition of a BN layer in order to form a super lattice structure.

## Patentansprüche

1. Chemisches Gasphasenabscheidungs-(CVD-)-Verfahren zum Abscheiden einer Diamant-, diamantartigen oder amorphen Kohlenstoffschicht, wobei das Verfahren die Einführung eines reaktiven Gases mit einer gasförmigen Kohlenstoffverbindung und einer Zugabe von Stickstoff in eine CVD-Reaktionskammer und das Anlegen von elektromagnetischer Energie zur Anregung der Kohlenstoffverbindung umfaßt, wodurch Kohlenstoff über eine chemische Gasphasenabscheidungsreaktion abgeschieden werden kann, und wobei das erfindungsgemäße Verfahren dadurch gekennzeichnet ist, daß der zugegebene Stickstoff als Stickstoffgas und/oder eine gasförmige Stickstoffverbindung in einer solchen Menge eingeführt wird, daß der abgeschiedene Kohlenstoff 0,01 bis 1,0 Gewichts-% Stickstoff enthält.

2. Verfahren nach Anspruch 1, wobei die elektromagnetische Anregungsenergie Mikrowellenenergie beinhaltet.

3. Verfahren nach Anspruch 2, wobei die Frequenz der Mikrowellenenergie gleich 2,45 GHz ist.

4. Verfahren nach Anspruch 2 oder 3, wobei die Reaktionskammer einem Magnetfeld unterliegt und die Anregung des reaktiven Gases, das eine gasförmige Kohlenstoffverbindung und Stickstoff oder eine gasförmige Stickstoffverbindung enthält, durch die Mikrowellenenergie unter dem Einfluß des Magnetfeldes bewirkt wird.

5. Verfahren nach Anspruch 4, wobei die Abscheidung unter dem Einfluß eines Magnetfeldes von wenigstens 1 Kilogauß ausgeführt wird.

6. Verfahren nach Anspruch 4 oder 5, wobei das reaktive Gas in einer Mischzyklotronresonanz angeregt wird.

7. Verfahren nach Anspruch 6, wobei der Druck in der Reaktionskammer so gewählt wird, daß er zwischen 13,3 $N/m^2$ und 4 x $10^4$ $N/m^2$ (0,1 Torr und 300 Torr) liegt.

8. Verfahren nach einem der vorstehenden Ansprüche, wobei die gasförmige Stickstoffverbindung Ammoniak ist.

9. Verfahren nach einem der vorstehenden Ansprüche, wobei das reaktive Gas wenigstens eine Kohlenwasserstoffverbindung einschließt, die die gasförmige Kohlenstoffverbindung bildet.

10. Verfahren nach Anspruch 9, wobei die Kohlenwasserstoffverbindung $C_2H_2$, $C_2H_4$ oder $C_2H_6$ umfaßt.

11. Verfahren nach einem der vorstehenden Ansprüche, wobei das reaktive Gas des weiteren eine gasförmige Borverbindung einschließt.

12. Verfahren nach einem der vorstehenden Ansprüche, wobei die Kohlenstoffschicht als kristalline Schicht oder als mikrokristalline Schicht abgeschieden wird.

13. Verfahren nach einem der Ansprüche 1 bis 11, wobei die Kohlenstoffschicht als amorphe Schicht abgeschieden wird.

14. Verfahren nach einem der vorstehenden Ansprüche, wobei die Kohlenstoffschicht wiederholt abwechselnd mit der Abscheidung einer BN-Schicht abgeschieden wird, um eine Übergitterstruktur zu bilden.

**Revendications**

1. Procédé de dépôt en phase gazeuse par procédé chimique (CVD) pour le dépôt d'un film de carbone diamant, de type diamant ou amorphe, ledit procédé comprenant l'introduction d'un gaz réactif comprenant un composé gazeux du carbone avec addition d'azote dans une chambre de réaction CVD et l'application d'énergie électromagnétique pour exciter ledit composé du carbone, ce par quoi du carbone peut être déposé par une réaction de dépôt en phase gazeuse par procédé chimique, le procédé étant caractérisé par le fait que l'azote additionné est introduit sous la forme d'azote gazeux et/ou d'un composé gazeux de l'azote, dans une quantité telle que le carbone déposé contient 0,01 à 1,0% en poids d'azote.

2. Procédé selon la revendication 1, dans lequel l'énergie d'excitation électromagnétique comprend l'énergie de micro-ondes.

3. Procédé selon la revendication 2, dans lequel la fréquence de ladite énergie de micro-ondes est de 2,45 GHz.

4. Procédé selon l'une des revendications 2 et 3, dans lequel la chambre de réaction est soumise à un champ magnétique, et l'excitation du gaz réactif contenant un composé gazeux du carbone, et de l'azote ou un composé gazeux de l'azote, par l'énergie de micro-ondes est effectuée sous l'influence dudit champ magnétique.

5. Procédé selon la revendication 4, dans lequel ledit dépôt est effectué sous l'influence d'un champ magnétique d'au moins 1 kilo Gauss.

6. Procédé selon l'une des revendications 4 et 5, dans lequel le gaz réactif est excité par une résonance cyclotron mixte.

7. Procédé selon la revendication 6, dans lequel la pression dans ladite chambre de réaction est choisie pour se situer entre 13,3 $N/m^2$ et 4 x $10^4$ $N/m^2$ (0,1 Torr et 300 Torr).

8. Procédé selon l'une quelconque des revendications précédentes, dans lequel le composé gazeux de l'azote est l'ammoniac.

9. Procédé selon l'une quelconque des revendications précédentes, dans lequel ledit gaz réactif comprend au moins un hydrocarbure constituant ledit composé gazeux du carbone.

10. Procédé selon la revendication 9, dans lequel ledit hydrocarbure comprend $C_2H_2$, $C_2H_4$ ou $C_2H_6$.

11. Procédé selon l'une quelconque des revendications précédentes, dans lequel le gaz réactif comprend en outre un composé gazeux du bore.

12. Procédé selon l'une quelconque des revendications précédentes, dans lequel ladite couche de carbone est déposée sous la forme d'une couche cristalline ou d'une couche microcristalline.

13. Procédé selon l'une quelconque des revendications 1 à 11, dans lequel ladite couche de carbone est déposée sous la forme d'une couche amorphe.

14. Procédé selon l'une quelconque des revendications précédentes, dans lequel ladite couche de carbone est déposée de façon répétée en alternance avec le dépôt d'une couche de BN de façon à former une structure super réticulaire.

FIG.1

# FIG.2(A)

# FIG.2(B)

# FIG.3(A)

# FIG.3(B)